# EUROPEAN PATENT APPLICATION

(11) **EP 4 811 416 A1**
(43) Date of publication of application: **23.09.2026**
(21) Application number: 24891103.4
(22) Date of filing: 30.09.2024
(51) Int. Cl.: H01J 37/20, G03F 7/20, H01J 37/28, H02K 41/02, H02K 41/03

(54) **STAGE DEVICE, VACUUM DEVICE, AND CHARGED PARTICLE BEAM DEVICE**

(30) Priority: 17.11.2023 JP 2023195592
(71) Applicant: Hitachi, Ltd., Tokyo 100-8280 (JP)
(72) Inventor: TAKAHASHI Motohiro, Tokyo 100-8280 (JP); KATO Takanori, Tokyo 100-8280 (JP); OGAWA Hironori, Tokyo 100-8280 (JP); KAMIGAKI Masahiro, Tokyo 100-8280 (JP); CHUMAN Takeru, Tokyo 100-8280 (JP)
(74) Representative: MERH-IP Matias Erny Reichl Hoffmann Patentanwälte PartG mbB
(86) International application number: PCT/JP2024/034870
(87) International publication number: WO 2025/105061

(57) **Abstract**

Provided is a stage device that suppresses vibration of a stator of a motor, and that enables high-speed positioning. The stage device comprises: a first table; a second table that is able to move within a horizontal plane in a state of magnetic levitation over the first table; a support section for supporting the second table; a first double-shaft motor provided to the support section; and a second double-shaft motor provided to the support section. The first double-shaft motor and second double-shaft motor each comprise: a yoke provided with an upper member and a lower member; and a first and a second rectangular coil which are located between the upper member and the lower member and are each fixed to the support section, and an axial direction of which is the vertical direction. On a lower surface of the upper member and an upper surface of the lower member, there are provided magnet arrays, in which magnets are arranged in square blocks arrayed in a grid so that adjacent blocks have different magnetic poles. The magnet array provided to the lower surface of the upper member and the magnet array provided to the upper surface of the lower member are configured so that magnets of blocks that face opposite in the vertical direction have different magnetic poles from one another.

## Description

### Technical Field

The present disclosure relates to a stage device, a vacuum device, and a charged particle radiation device.

### Background Art

As a technique for positioning and supporting a semiconductor wafer, a magnetic levitation stage device is known. For example, Patent Literature 1 describes a magnetic levitation stage device. Column 0020 and FIG. 1(a) of Patent Literature 1 disclose that "an actuator which moves a stage YM is disposed on the bottom face of the stage YM. As movable elements of the actuator, magnet units XAM, YAM, and ZAM are provided. ... The two magnet units YAM move the stage YM in the Y-axis direction. ... The magnet units XAM, YAM, and ZAM have hollow structures so that coils XAC, YAC, and ZAC as stators of the actuator corresponding to the magnet units XAM, YAM, and ZAM can penetrate, respectively". Column 0021 of Patent Literature 1 discloses that "the magnet unit YAM has magnets YAMM disposed above and below the coil YAC, and each of the magnets YAMM is sandwiched by yokes YAMY in the vertical direction. Further, the yokes YAMY are fixed by an intermediate member YAMI. In the Y-axis direction, magnets YAMM of different magnetic poles are alternately arranged". Column 0025 and FIG. 2(a) of Patent Literature 1 disclose that "the coil YAC is configured by a multiphase coil and can move the stage YM for long distance in the Y-axis direction".

### Citation List

### Patent Literature

Patent Literature 1: Japanese Unexamined Patent Application Publication No. 2015-198121

### Summary of Invention

### Technical Problem

That is, in the magnetic levitation stage device of Patent Literature 1, the magnet unit YAM has a hollow structure, and moves for long distance in the Y-axis direction along the coil YAC penetrating the hollow part of the magnet unit YAM. Since the magnet unit YAM moves in such a manner, the coil YAC has a structure that only both ends are fixed and the center part is not in contact with other objects.

In processes of manufacture, measurement, inspection, and the like of a semiconductor wafer, a stage device is required to have performance of high-speed and high-precision positioning of a semiconductor wafer. The magnetic levitation stage device of Patent Literature 1, however, has a problem such that in the case where a stroke in the Y-axis direction is long, the coil YAC which is fixed by only their ends vibrates, so that the natural vibration frequency of the stage device is low, improvement in the control bandwidth is regulated, and it is difficult to perform high-speed positioning.

An object of the present disclosure is to provide a stage device, a vacuum device, and a charged particle radiation device capable of suppressing vibration of a stator of a motor and performing high-speed positioning.

### Solution to Problem

A stage device of the present disclosure is, for example, a stage device for positioning a sample stage in a horizontal plane, having: a first table; a second table provided with the sample stage, and capable of moving in the horizontal plane in a state where it is magnetically levitated from the first table; a supporting unit for supporting the second table; a first dual-axis motor provided for the supporting unit; and a second dual-axis motor provided for the supporting unit. Each of the first and second dual-axis motors includes: a yoke having an upper-side member and a lower-side member; and first and second rectangular coils positioned between the upper-side member and the lower-side member, each fixed to the supporting unit, and whose axial direction is a vertical direction. A magnet array in which magnets are disposed in square sections arranged in a lattice shape so that magnetic poles in neighboring sections are different is provided in each of an under face of the upper-side member and a top face of the lower-side member, and the magnetic poles of the magnets in the sections in the magnet array provided for the under face of the upper-side member and those in the magnet array provided for the top face of the lower-side member, which are opposed to each other in the vertical direction are different from each other.

A vacuum device of the present disclosure has, for example, the stage device and a vacuum chamber housing the stage device and whose inside is in a vacuum state.

A charged particle radiation device of the present disclosure has, for example, the stage device, a vacuum chamber housing the stage device and whose inside is in a vacuum state, and an electron optical system lens tube which emits an electron beam to a sample placed on the stage device. Advantageous Effects of Invention

According to the present disclosure, the stage device, the vacuum device, and the charged particle radiation device capable of suppressing vibration of the stator of the motor and performing high-speed positioning can be provided. The other objects and novel features will become apparent from the description of the specification and appended drawings.

### Brief Description of Drawings

FIG. 1 is a diagram illustrating a configuration example of a stage device using a rolling guide of a first comparison example.
FIG. 2 is a diagram illustrating a configuration example of a magnetic levitation stage device of a second comparison example.
FIG. 3 is a diagram illustrating a configuration example of an X-axis motor of the second comparison example.
FIG. 4 is a diagram illustrating a configuration example of an Y-axis motor of the second comparison example.
FIG. 5 is a diagram illustrating a configuration example of an Z-axis motor of the second comparison example.
FIG. 6 is a diagram illustrating an example of a vibration mode in which a yoke curves in the Y-axis direction.
FIG. 7 is a diagram illustrating a configuration example of a magnetic levitation plane stage device of a third comparison example.
FIG. 8 is a diagram illustrating a configuration example of a planar motor of the third comparison example.
FIG. 9 is a B-B cross section of FIG. 8.
FIG. 10 is a schematic diagram of a stage device 1 of a first embodiment.
FIG. 11 is a cross section of a YZ plane of the stage device.
FIG. 12 is an A-A cross section of FIG. 11.
FIG. 13 is a diagram illustrating a lower-side magnet array and a first three-phase coil positioned above the array.
FIG. 14 is a diagram illustrating the lower-side magnet array and a second three-phase coil positioned above the array.
FIG. 15 is a diagram viewing an upper-side magnet array from the negative side in a Z-axis direction.
FIG. 16 is a side view of a yoke for a dual-axis motor.
FIG. 17 is a diagram for explaining a modification of the yoke for the dual-axis motor.
FIG. 18 is the A-A cross section of FIG. 11 in a second modification.
FIG. 19 is the A-A cross section of FIG. 11 in a third modification.

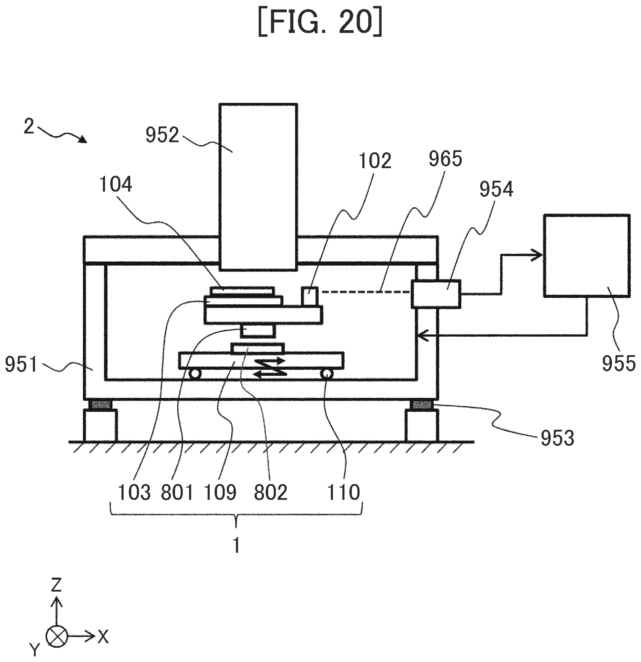

FIG. 20 is a schematic cross section of a semiconductor measuring device in which the stage device of the present disclosure is mounted.

### Description of Embodiments

First, the problem of a conventional stage device will be described by using comparative examples.

### (First Comparative Example)

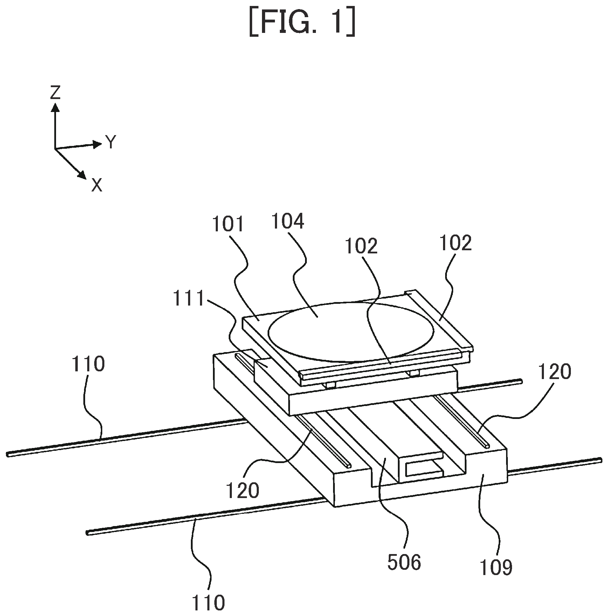

FIG. 1 is a diagram illustrating a configuration example of the stage device using a rolling guide of a first comparison example. The stage device illustrated in FIG. 1 has a stack-type stage configuration using rolling guides in both an X axis and a Y axis. A Y table 109 is guided by a Y-axis guide 110, and an X table 111 is guided by an X-axis guide 120. A sample 104 and a top table 101 to which a bar mirror 102 is fixed are mounted on the X table 111. The bar mirror 102 is used for measuring the position of the sample 104 by a laser interferometer or the like. A yoke 506 of an X-axis linear motor is fixed on the Y table 109, and a coil (not illustrated) of the X-axis linear motor is fixed to the X table 111. With the configuration, thrust in the X-axis direction is given to the coil of the linear motor, and the X-axis direction thrust is given to the X table 111. In the yoke 506, the reaction force in the direction opposite to the X-axis direction thrust given to the coil of the linear motor is generated. The stage device of the first comparison example has a problem that the positioning precision of the sample 104 is low.

### (Second Comparative Example)

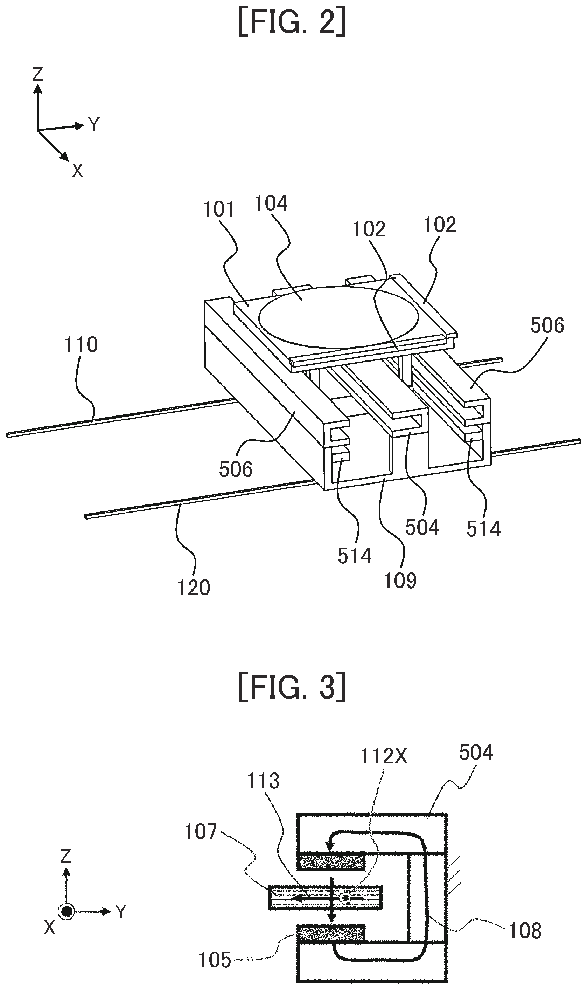

FIG. 2 is a diagram illustrating a configuration example of a magnetic levitation stage device of a second comparison example. This comparative example relates to a configuration that the top table 101 is guided by magnetic levitation from the Y table 109. In the magnetic levitation stage device, by making the guidance in a noncontact manner, positioning precision can be improved. On the other hand, it is necessary to control displacements in the X-, Y-, and Z-axis directions with respect to the top table 101 and positions and postures in six degrees of freedom around the XYZ axes. Consequently, while one X-axis motor is sufficient in the stage device of FIG. 1 in which the top table 101 is not magnetically levitated, the number of axes of a motor as a drive element increases to six. Concretely, in the first comparative example, the displacements in the Y-axis direction and the Z-axis direction are restrained by the X-axis guide 120. On the other hand, in the magnetic levitation stage device (second comparative example), since there is no X-axis guide 120, the Y-axis motor and the Z-axis motor for restraining dispositions in the Y-axis direction and the Z-axis direction are necessary. As illustrated in FIG. 2, a yoke 504 of the X-axis motor has a rod shape and has a configuration that only both ends are fixed to the Y table 109, so that vibration easily occurs. In such a magnetic levitation stage device in which a stroke is long in one direction, a number of yokes of a linear motor as a rod-shape structure are necessary. Since some of the yokes are fixed by only both ends, the natural vibration frequency is low, the control bandwidth is regulated, and it is difficult to achieve higher speed. In addition, low assembly/maintenance performance is also a problem.

FIG. 3 is a diagram illustrating a configuration example of the X-axis motor. A magnetic flux 108 is generated by a permanent magnet 105 and the U-shaped yoke 504. By a direction 113 of current passed to a coil 107, an X-axis direction thrust 112X is obtained by Lorentz force. To generate a stroke of a few hundred mm in the X-axis direction, a three-phase AC linear motor may be used.

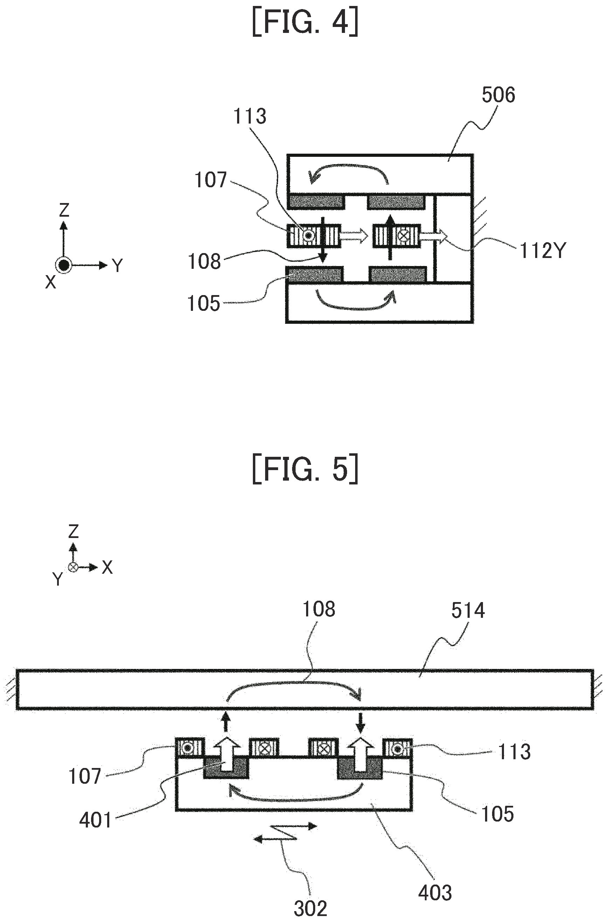

FIG. 4 is a diagram illustrating a configuration example of the Y-axis motor. The magnetic flux 108 is generated by the permanent magnet 105 and the U-shaped yoke 506. By the direction 113 of current passed to the coil 107, an Y-axis direction thrust 112Y is obtained by Lorentz force. To increase a stroke in the Y-axis direction, the Y-axis direction length of the permanent magnet 105 has to be increased. Consequently, the Y-axis direction dimension of the yoke 506 increases.

FIG. 5 is a diagram illustrating a configuration example of the Z-axis motor. A magnetic attractive force 401 between the permanent magnet 105 and a guide yoke 514 is used for compensation of the gravity of a levitation unit. The magnetic flux 108 is formed in a loop shape in the guide yoke 514 and a back yoke 403. The magnetic flux 108 is increased/decreased according to the direction 113 of current passed in the coil 107, and the magnetic attractive force 401 is accordingly increased and decreased. As a result, the force in the Z-axis direction can be controlled.

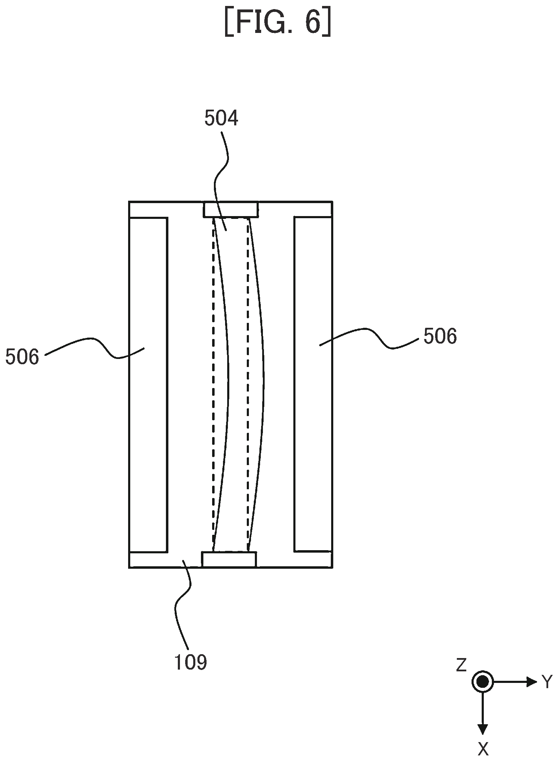

FIG. 6 is a diagram illustrating an example of a vibration mode in which the yoke 504 curves in the Y-axis direction. Different from the yoke 506 whose entire long-side direction can be fixed to the Y table 109, only both ends of the yoke 504 are fixed. Consequently, as illustrated in FIG. 6, the yoke 504 easily vibrates in a mode shape curved in the Y-axis direction.

### (Third Comparative Example)

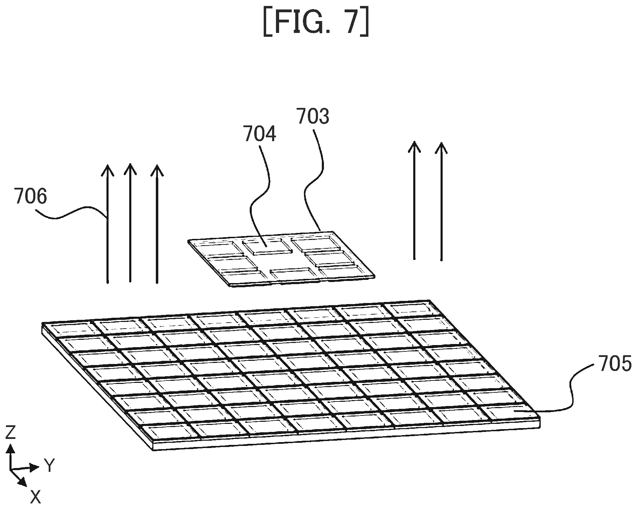

FIG. 7 is a diagram illustrating a configuration example of a magnetic levitation plane stage device of a third comparison example. In a levitation table 703, a coil 704 is enveloped. The positions in the 6-degrees of freedom and the postures of the levitation table 703 are controlled by electromagnetic force between a magnet array 705 laid on the fixed side and the coil 704, thereby realizing contactless support and positioning. Such a motor capable of moving in long strokes in two axes of the XY plane will be called a planar motor. In such a magnetic levitation plane stage device, as compared with the magnetic levitation stage device of the stack type of FIG. 2, since the movable masses in the two directions of the X-axis direction and the Y-axis direction are the same and light, the response is higher. On the other hand, since leakage flux is generated from the magnet array 705, installation to the charged particle radiation device is difficult.

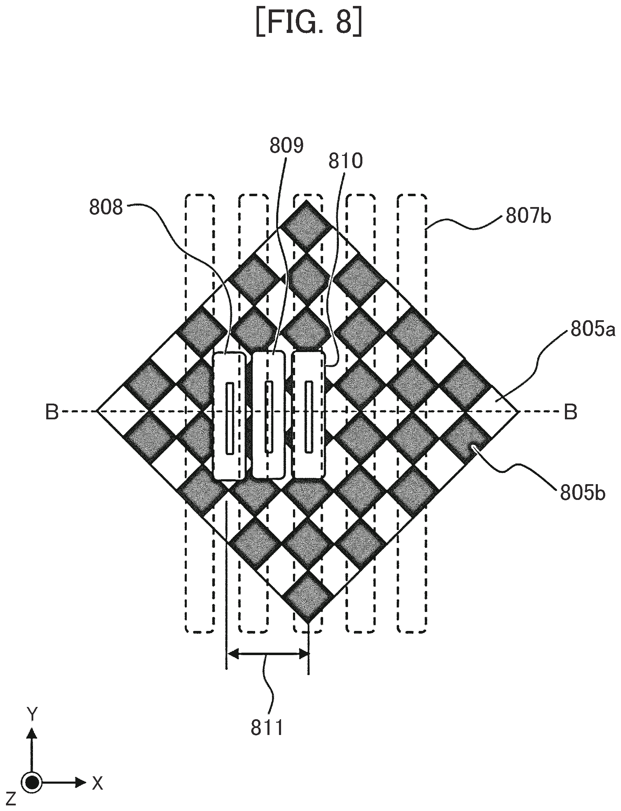

FIG. 8 is a diagram illustrating a configuration example of the planar motor of the third comparison example. The magnet array 705 illustrated in FIG. 7 is configured by a layout in which magnets 805a whose N pole is positioned upper and magnets 805b whose S pole is positioned upper are alternately arranged as illustrated in FIG. 8. A coil which generates thrusts in the X-axis direction and the Z-axis direction on the levitation table side is configured by a U-phase coil 808, a V-phase coil 809, and a W-phase coil 810. In FIG. 8, a group 807b of the magnets 805b whose S pole is on the upper side, that is, facing the positive side in the Z-axis direction is surrounded by a dotted line. Each of the groups 807b is regarded as a group of magnets whose S pole is on the upper side, and magnets between the groups 807b can be regarded as magnets whose N pole is on the upper side. A B-B cross section of this configuration will be described.

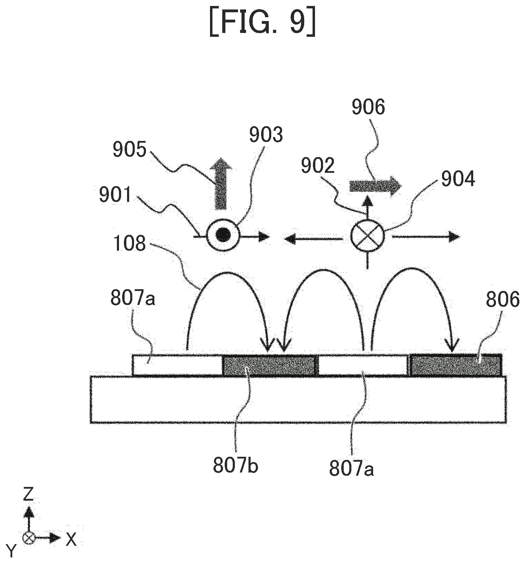

FIG. 9 is the B-B cross section of the planar motor of the third comparative example illustrated in FIG. 8. The group 807b in FIG. 8 will be called S-pole magnets 807b, and a part which can be regarded as a magnet whose N pole is on the upper side between the S-pole magnets 807b will be called an N-pole magnet 807a. When a coil current 903 is generated for a horizontal component 901 of the magnetic flux 108 configured by the N-pole magnet 807a and the S-pole magnet 807b, a vertical-direction thrust 905 is obtained by the Lorentz force. By a vertical component 902 of the magnetic flux and a coil current 904, a horizontal-direction thrust 906 is obtained. By controlling current values of the U-phase coil 808, the V-phase coil 809, and the W-phase coil 810 in FIG. 8 like in a three-phase AC linear motor, the desired X-axis direction thrust and the desired Z-axis direction thrust are obtained. By turning the direction of the coil in FIG. 8 around the Z axis by 90 degrees, the Y-axis direction thrust and the Z-axis direction thrust can be generated. In such a manner, the thrusts in two-axis directions can be generated in a planar motor.

That is, in the magnetic levitation stage device of the stack type as illustrated in FIG. 2 using the linear motor as illustrated in FIGS. 3 to 5, although the leakage magnetic field is small, high-response movement in a few hundred mm scale in the two axes of X and Y is difficult. In the magnetic levitation planar stage device as illustrated in FIG. 7, although high-response movement in a few hundred mm stroke is possible in two axes of X and Y, the leakage magnetic field is large, and installation to the charged particle radiation device is difficult.

The problems in the above-described comparison examples are summarized as follows. The stage device of the first comparison example has the problem that the precision of positioning the sample 104 is low. The magnetic levitation stage device of the second comparative example has the problem that high-responsive movement (high-speed positioning) in a few hundred mm scale in two axes of X and Y is difficult. The magnetic levitation planar stage device of the third comparative example has the problem that the leakage magnetic field is large. A stage device solving the problems of the first to third comparative examples will be described later.

### First Embodiment

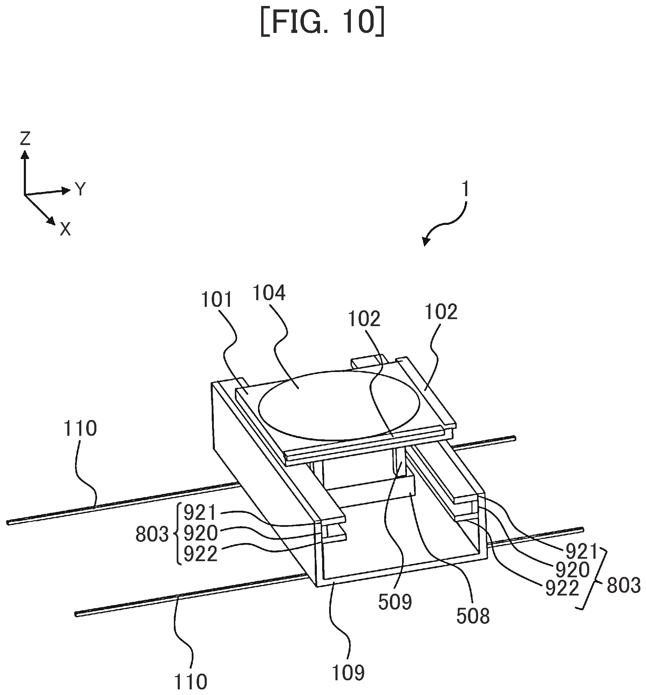

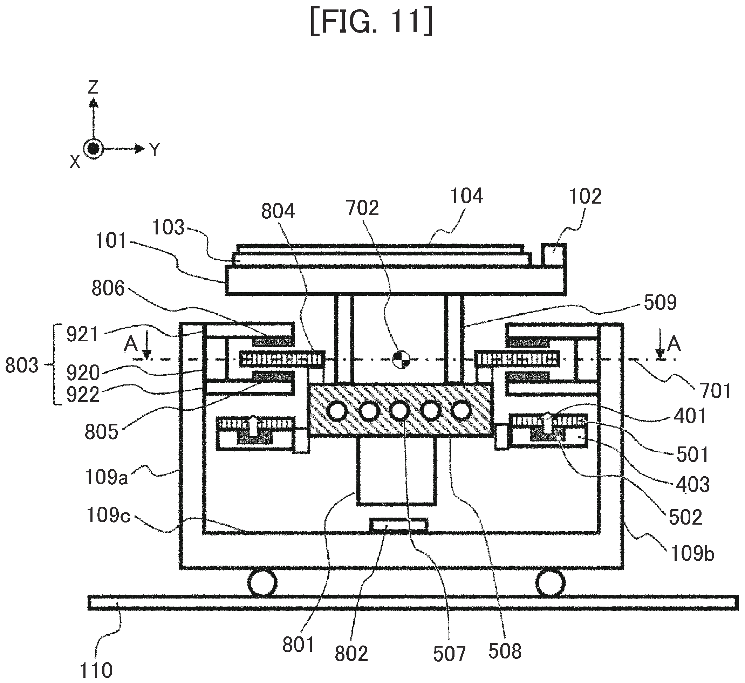

FIG. 10 is a schematic diagram of a stage device 1 of a first embodiment. FIG. 11 is a cross section of a YZ plane of the stage device. In FIG. 10, to facilitate understanding, a part of the configuration illustrated in FIG. 11 is omitted. In the following, the Z-axis direction corresponds to the vertical direction, the Y-axis direction corresponds to a first horizontal direction, and the X-axis direction corresponds to a second horizontal direction.

As illustrated in FIG. 10, the stage device 1 has the Y table 109 (first table). The Y table 109 can move in the Y-axis direction along the Y-axis guide 110. As illustrated in FIG. 11, the Y table 109 has a first side wall 109a and a second side wall 109b facing the Y-axis direction and extending in the X-axis direction, and a bottom 109c connecting the first side wall 109a and the second side wall 109b.

In the present embodiment, a configuration including a support pole 509 and a water-cooling jacket 508 illustrating in FIG. 11 will be called a support part. The support part is positioned between the first side wall 109a and the second side wall 109b of the Y table 109. A scale head 801 is fixed to the water-cooling jacket 508, and recognizes a scale plate 802 fixed to the bottom 109c of the Y table 109. The stage device 1 grasps the position of the top table 101 relative to the Y table 109 on the basis of the recognition result of the scale head 801.

The top table 101 (second table) is mounted on the upper end of the support pole 509. The top table 101 is provided with the bar mirror 102 used for measuring the position of the top table 101 and a sample stage 103 on which the sample 104 is placed. The top plate 101 is movable in the horizontal plane in a state where it is magnetically levitated from the Y table 109. The elements fixed to the support part such as the top table 101, a coil 804 for a dual-axis motor, a coil 501, and the like constitute a levitation unit which levitates from the Y table 109.

A water-cooling pipe 507 lies in the water-cooling jacket 508, and cools the parts fixed to the water-cooling jacket 508. Specifically, in the present embodiment, the water-cooling jacket 508 water-cools the coil 804 for a dual-axis motor, the coil 501, and the scale head 801. In such a manner, heat generation by a heat generation source such as the coil 804 for the dual-axis motor, the coil 501, and the like can be suppressed.

The stage device 1 of the present embodiment has, as illustrated in FIG. 11, the dual-axis motor having a dual-axis motor yoke 803 and the dual-axis motor coil 804 each between the first side wall 109a and the support part and between the second side wall 109b and the support part.

The dual-axis motor yoke 803 has an upper-side member 921, a lower-side member 922, and an upper and lower yoke connecting part 920. The dual-axis motor yoke 803 positioned between the first side wall 109a and the support part is fixed to the first side wall 109a, and the dual-axis motor yoke 803 positioned between the second side wall 109b and the support part is fixed to the second side wall 109b.

The stage device has a lower-side magnet array 805 provided on the top face of the lower-side member 922 of the dual-axis motor yoke 803, and an upper-side magnet array 806 provided on the undersurface of the upper-side member 921.

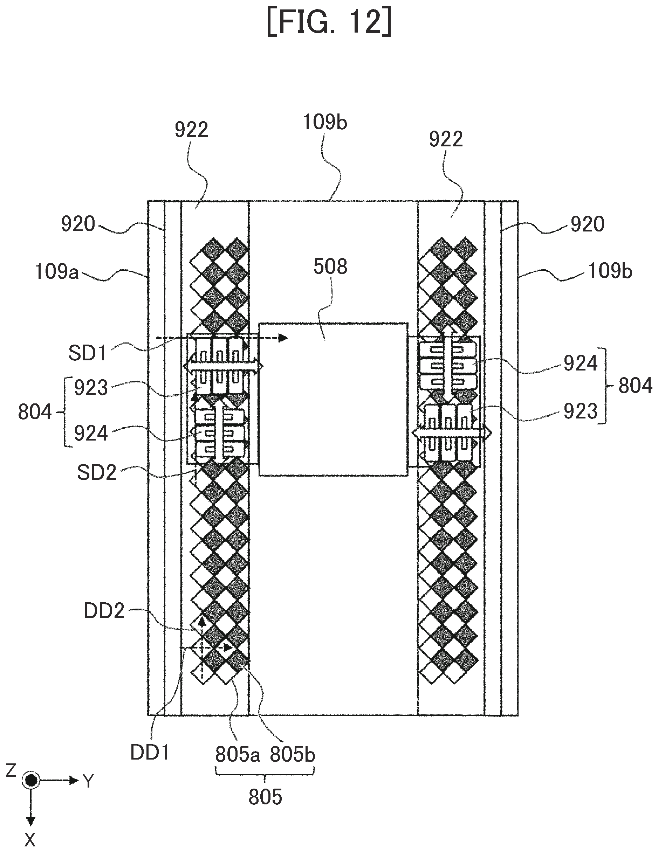

FIG. 12 is an A-A cross section of FIG. 11. In the lower-side magnet array 805, the N-pole magnets 805a and the S-pole magnets 805b are arranged in square sections arranged in a lattice shape so that the magnetic poles of neighboring sections are different from each other. In the lower-side magnet array 805 of the present embodiment, a diagonal line direction DD1 as one of diagonal line directions of a section is parallel to the Y-axis direction, and the other diagonal line direction DD2 of the section is parallel to the X-axis direction.

The dual-axis motor coil 804 has a first three-phase coil 923 and a second three-phase coil 924. As illustrated in FIG. 11, each of the first three-phase coil 923 and the second three-phase coil 924 is positioned between the upper-side member 921 of the dual-axis motor yoke 803 and the lower-side member 922 and is fixed to the support part. As illustrated in FIG. 12, the first three-phase coil 923 has three first rectangular coils. The axis direction of the three first rectangular coils is the Z-axis direction (vertical direction), and the first rectangular coils are arranged in a short-side direction SD1. The first three-phase coil 923 is fixed to the water-cooling jacket 508 so as to be positioned between the support part and the side wall 109a or the side wall 109b of the Y table 109. At this time, the first three-phase coil 923 is disposed so that the short-side direction SD1 of the first rectangular coil is parallel to the diagonal line direction DD1 as one of the diagonal line directions of the section in the lower-side magnet array 805. The second three-phase coil 924 has three second rectangular coils. The axis direction of the three second rectangular coils is the Z-axis direction (vertical direction), and the first rectangular coils are arranged in a short-side direction SD2. The second three-phase coil 924 is fixed to the water-cooling jacket 508 so as to be positioned between the support part and the side wall 109a or the side wall 109b of the Y table 109. At this time, the second three-phase coil 924 is disposed so that the short-side direction SD2 of the first rectangular coil is parallel to the diagonal line direction DD2 as another diagonal line directions of the section in the lower-side magnet array 805.

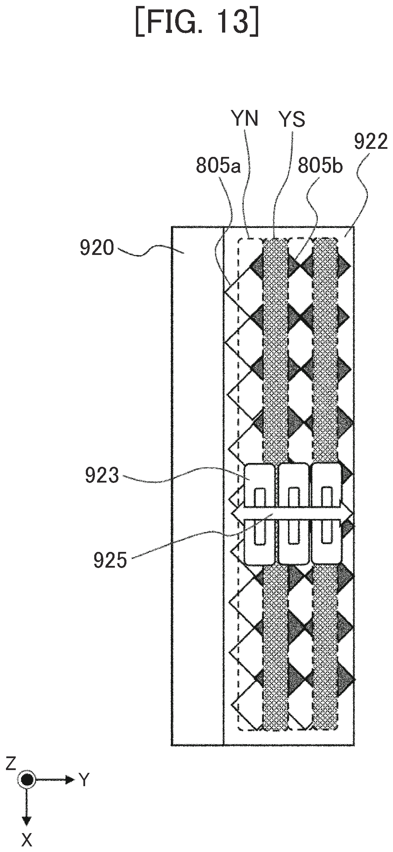

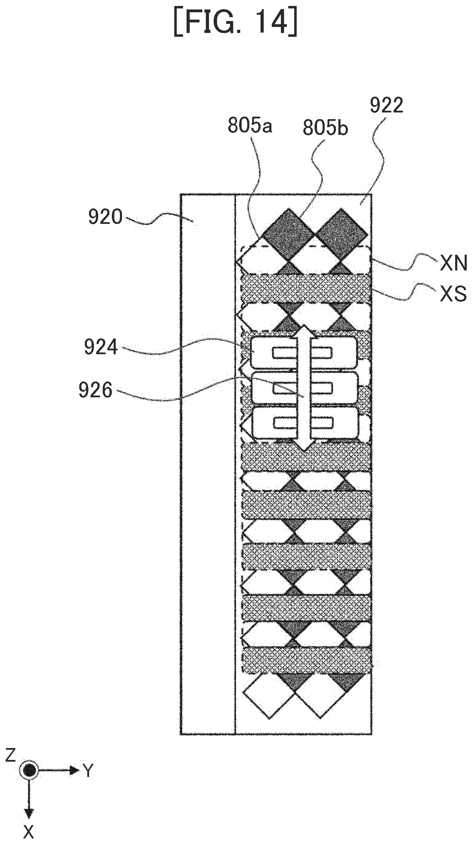

With reference to FIGS. 13 to 16, the action of the first three-phase coil 923, the second three-phase coil 924, the lower-side magnet array 805, and the upper-side magnet array 806 will be described. FIG. 13 illustrates the lower-side magnet array 805 and the first three-phase coil 923 positioned above the array. In the lower-side magnet array 805, it can be regarded that virtual N poles YN and virtual S poles YS are alternately arranged in the Y-axis direction. The virtual N pole YN is an area in which the N-pole magnets 805a are dominant, and the virtual S pole YS is an area in which the S-pole magnets 805b are dominant. The border between the virtual N pole YN and the virtual S pole YS which are neighboring can be set so as to pass the midpoint of a side of a section in which a magnet is disposed. FIG. 14 illustrates the lower-side magnet array 805 and the second three-phase coil 924 positioned above the array. In the lower-side magnet array 805, it can be regarded that virtual N poles XN and virtual S poles XS are alternately arranged in the X-axis direction. Similarly, the virtual N pole XN is an area in which the N-pole magnets 805a are dominant, and the virtual S pole XS is an area in which the S-pole magnets 805b are dominant. The border between the virtual N pole XN and the virtual S pole XS which are neighboring can be set so as to pass the midpoint of a side of a section in which a magnet is disposed. Therefore, the stage device 1 of the present embodiment can generate thrusts in two axes by a Y-axis direction thrust 925 and an X-axis direction thrust 926.

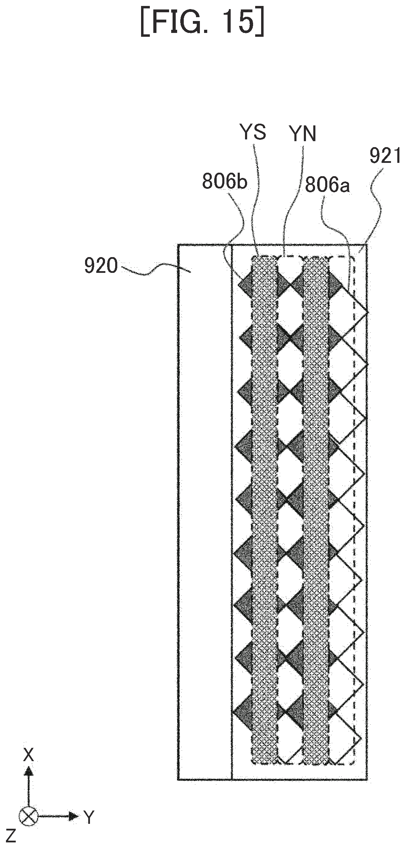

On the other hand, FIG. 15 is a diagram viewing the upper-side magnet array 806 from the negative side in the Z-axis direction. Like the low-side magnet array 805 illustrated in FIG. 12, in the upper-side magnet array 806, N-pole magnets 806a and S-pole magnets 806b are disposed in square sections arranged in a lattice shape so that the magnetic poles in neighboring sections are different. Further, the N-pole magnets 806a and the S-pole magnets 806b are arranged so that the sections in the upper-side magnet array 806 face the sections in the lower-side magnet array 805 in the vertical direction and the magnetic pole in each of the upper-side magnet array 806 differs from the magnetic pole in the facing section in the low-side magnet array 805. As a result, in the upper-side magnet array 806, like in the lower-side magnet array 805, it can be regarded that the virtual N poles YN and the virtual S poles YS are alternately arranged in the Y-axis direction. The upper-side magnet array 806 can be regarded that the virtual N poles XN and the virtual S poles XS are alternately arranged also in the X-axis direction.

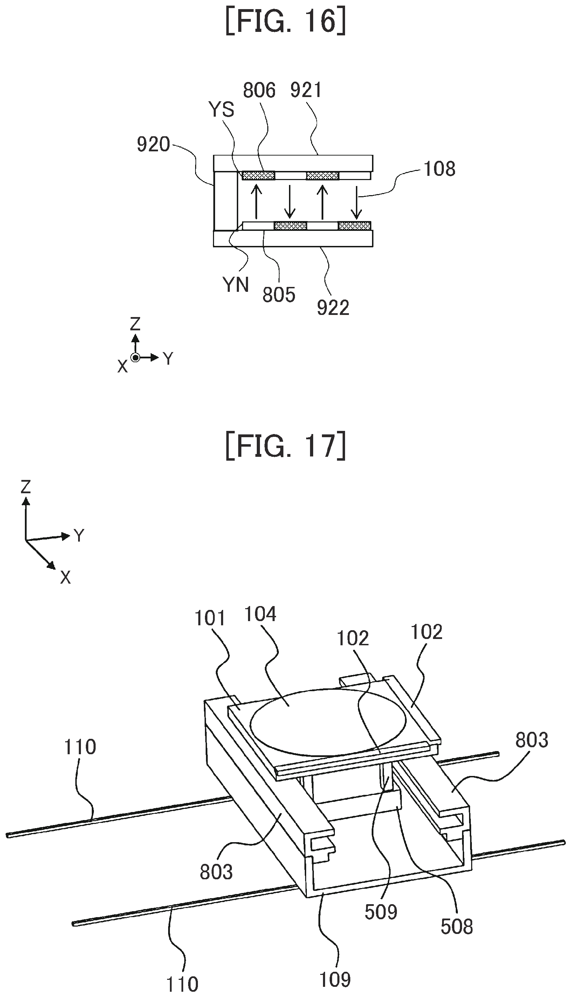

FIG. 16 is a side view of the yoke 803 for the dual-axis motor. As illustrated in FIGS. 15 and 16, in the upper-side magnet array 806, the virtual S poles YS and the virtual N poles YN are alternately arranged from the negative side in the Y-axis direction toward the positive side. On the other hand, in the lower-side magnet array 805, as illustrated in FIGS. 13 and 16, the virtual N poles YN and the virtual S poles YS are alternately arranged from the negative side in the Y-axis direction toward the positive side. Therefore, as illustrated in FIG. 16, the magnetic poles in the facing parts in the upper-side magnet array 806 and the lower-side magnet array 805 are different, and the magnetic flux 108 from one of the upper-side magnet array 806 and the lower-side magnet array 805 to the other is generated.

By the magnetic fluxes 108 illustrated in FIG. 16, the first three-phase coil 923 and the second three-phase coil 924 generate thrusts. First, attention is paid to one of the rectangular coils constructing the first three-phase coil 923. As illustrated in FIG. 13, the rectangular coil has a size that, for example, the width in the short-side direction is equal to or larger than the half of length of a diagonal line of a section and is equal to or less than the length of the diagonal line of the section, the side face on the long side is included in the virtual N pole YN (virtual S pole YS), and the opposed side face is included in the virtual S pole YS (virtual N pole YN). Consequently, when current is passed to the rectangular coils, thrust is generated in the same Y direction in each of the rectangular coil part on the virtual N pole YN and the rectangular coil part on the virtual S pole YS, thereby generating the Y-axis direction thrust 925. For a similar reason, also in the second three-phase coil 924 illustrated in FIG. 14, by passing current to the rectangular coil, the X-axis direction thrust 926 is generated. Further, by making a three-phase coil by combining three rectangular coils of the U-phase coil, the V-phase coil, and the W-phase coil, drive distance can be increased.

Thrust can be generated also in the short-side part of each of the rectangular coils constructing the first three-phase coil 923 and the second three-phase coil 924. However, the thrust in the X-axis direction generated in the first three-phase coil 923 can be suppressed to the degree that it can be ignored with respect to the X-axis direction thrust 926 generated by the second three-phase coil 924, and the thrust in the Y-axis direction generated by the second three-phase coil 924 can be suppressed to the degree that it can be ignored with respect to the Y-axis direction thrust generated by the first three-phase coil 923.

As described above, since the magnetic circuit is closed between the upper-side member 921 and the lower-side member 922, the leakage magnetic field from the upper-side magnet array 806 and the lower-side magnet array 805 is small. Consequently, the stage device 1 of the present embodiment can be mounted in the charged particle radiation device.

In the present embodiment, as illustrated in FIG. 12, the first three-phase coil 923 and the second three-phase coil 924 are alternately arranged for the water-cooling jacket 508. Specifically, the dual-axis motor yoke 803 positioned between the first side wall 109a and the supporting unit has the first three-phase coil 923 on one end of the first side wall 109a and has the second three-phase coil 924 on the other end of the first side wall 109a. The dual-axis motor yoke 803 positioned between the second side wall 109b and the supporting unit has the second three-phase coil 924 on one end of the second side wall 109b opposed to one end of the first side wall 109a in the Y-axis direction and has the first three-phase coil 923 on the other end of the second side wall 109b.

As described above, by installing the first three-phase coils 923 fixed on both sides in the Y-axis direction of the water-cooling jacket 508 while being deviated in the X-axis direction so as not to overlap in the Y-axis direction, the Y-axis direction thrusts 925 generated in the two first three-phase coils 923 can be generated apart from each other in the X-axis direction. By providing a difference in the Y-axis direction thrusts 925, a torque in the rotation direction around the Z axis is generated, and the posture around the Z axis can be controlled. Similarly, by installing the second three-phase coils 924 fixed on both sides in the Y-axis direction of the water-cooling jacket 508 while being deviated in the X-axis direction so as not to overlap in the Y-axis direction, the two X-axis direction thrusts 926 generated in the two second three-phase coils 924 can be generated apart from each other in the X-axis direction. By providing a difference in the X-axis direction thrusts 926, the posture around the Z axis can be controlled.

Next, the Z-axis direction thrust will now be described with reference to FIG. 11. The stage device 1 has, as a configuration related to the Z-axis direction thrust, the back yoke 403, a magnet 502 for magnetic levitation, and the coil 501. The back yoke 403 is fixed to the water-cooling jacket 508 so as to be positioned on the lower side in the Z-axis direction (vertical direction) of the lower-side member 922 of the dual-axis motor yoke 803. The magnet 502 for magnetic levitation is fixed to the top face of the back yoke 403 and makes the lower-side member 922 generate the magnetic attractive force 401. The magnetic attractive force 401 becomes levitation force for gravity compensation of the supporting unit and the top table 101, makes the supporting unit and the top table 101 magnetically levitate, and further, becomes the Z-axis direction thrust. The coil 501 is fixed to the top face of the back yoke 403 so as to be positioned between the dual-axis motor yoke 803 and the magnet 502 for magnetic levitation. By passing current to the coil 501, the magnetic attractive force 401 is controlled. In such a manner, the back yoke 403, the magnet 502 for magnetic levitation, and the coil 501 constitute a vertical motor together with the lower-side member 922 of the dual-axis motor yoke 803. As an example of the coil 501, a single-phase coil whose axis direction is the Z-axis direction can be mentioned.

The vertical motor makes the levitation unit levitate magnetically so that the height of the first three-phase coil 923 and the second three-phase coil 924 of each of the dual-axis motor coils 804 positioned on both sides of the supporting unit matches the height of gravity 702 of the levitation unit. By the operation, a drive center 701 of a dual-axis motor configured by the dual-axis motor yoke 803 and the dual-axis motor coil 804 coincides with the gravity 702 of the levitation unit. As a result, the pitching moment in movement in the X-axis direction and the Y-axis direction of the levitation unit becomes smaller, the current to the coil 501 used for posture fluctuation and posture control can be decreased, and lower heat generation can be achieved.

In the vertical motor of the present embodiment, the top of the magnet 502 for magnetic levitation is covered with the dual-axis motor yoke 803, so that the leakage flux from the magnet 502 for magnetic levitation is shielded. As illustrated in FIG. 11, due to the structure that the magnet 50 for magnetic levitation is attached to the under face of the dual-axis motor yoke 803, it is unnecessary to provide the guide yoke 514 illustrated in FIG. 2, so that the weight of the stage device 1 can be reduced.

The stage device 1 of the present embodiment has a configuration having the magnetic levitation guide which performs contactless movement guide of the top table 101. By the configuration, the position precision is improved. In the stage device 1 of the present embodiment, by providing the planar motor, high-speed movement in the two-axis plane of X and Y of the dual-axis motor coil 804 can be performed within the range of the lower-side member 922 illustrated in FIG. 12. In the case of applying the stage device 1 to a semiconductor inspection device or the like, positioning in the range of about 20 mm corresponding to one general chip can be performed at speed as high as a magnetic levitation plane stage device.

As described above, the stage device 1 of the present embodiment can suppress leakage magnetic field to the outside. Consequently, it can be applied to a device requiring low magnetic field such as the charged particle radiation device. The stage device 1 of the present embodiment does not require a linear motor in the X-axis direction illustrated in FIG. 2, and the magnetic material decreases. Therefore, interference with the magnetic field generated by a magnetic field deflector lens in an electronic optical system which becomes a problem in a charged particle radiation device and the like is reduced. Consequently, distortion of an electron beam decreases, and an excellent image is obtained.

In the stage device 1 of the present embodiment, the whole in the X-axis direction as the extension direction of the dual-axis motor yoke 803 is fixed to the side wall 109a or the side wall 109b of the Y table 109, so that vibration is suppressed, and the natural vibration frequency becomes high. Therefore, the control bandwidth regulated by the natural vibration frequency of the yoke 504 can be improved in the magnetic levitation stage device as illustrated in FIG. 2. The number of parts is small, and lead time can be also shortened. As long as necessary control bandwidth can be obtained even when the dual-axis motor yoke 803 is not fixed to the side wall 109a or the side wall 109b of the Y table 109, the present disclosure is not limited to the arrangement in the embodiment. For example, there is a case that the length in the X-axis direction of the dual-axis motor yoke 803 is sufficiently short or rigidity is high, so that vibration is suppressed.

In the present embodiment, the example that the dual-axis motor coil 804 has the first three-phase coil 923 and the second three-phase coil 924 has been described. The disclosure is not limited to the example. It is sufficient that at least one first rectangular coil and one second rectangular coil are provided.

In the present embodiment, the example that each of the lower-side magnet array 805 and the upper-side magnet array 806 is a square-shaped lattice array has been described. The present disclosure, however, is not limited to the example. For example, a Halbach array in which a space is provided between the N-pole magnet 805a and the S-pole magnet 805b, and a magnet whose magnetic field direction is the direction in an XY plane is inserted in the space may be used.

As described above, according to the present embodiment, the stage device capable of suppressing vibration of the stator of the motor and performing high-speed positioning can be provided.

### (First Modification)

FIG. 17 is a diagram for explaining a modification of the dual-axis motor yoke 803. In the dual-axis motor yoke 803, the upper-side member 921, the lower-side member 922, and the upper and lower yoke connecting part 920 are integrated. A notch is formed in the lower part of the dual-axis motor yoke 803, and the notched part is fixed to the side wall 109a or the side wall 109b of the Y table 109.

### (Second Modification)

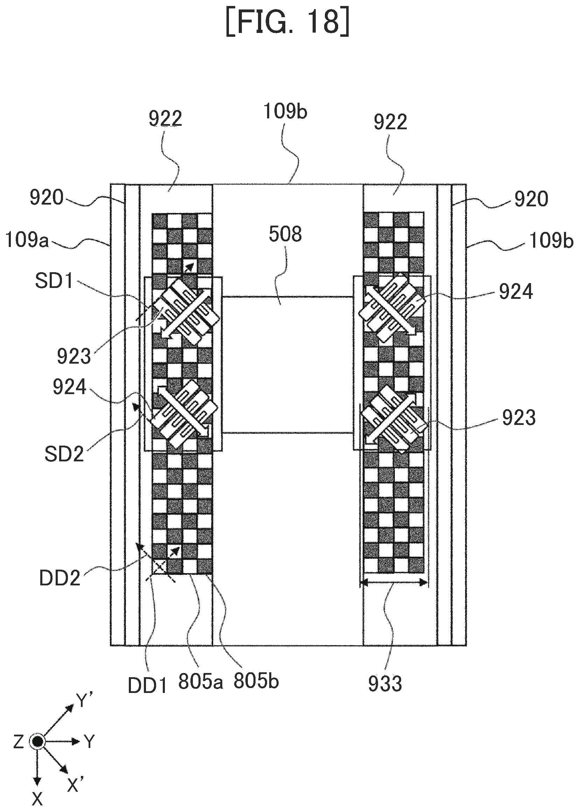

As a second modification, a modification of the direction of the lattice shape of the lower-side magnet array 805 and the directions of the first three-phase coil 923 and the second three-phase coil 924 will be described. FIG. 18 is the A-A cross section of FIG. 11 in a second modification. In the first embodiment, as illustrated in FIG. 12, the diagonal line direction DD1 of the section in the lower-side magnet array 805 and the short-side direction SD1 of the first rectangular coil of the first three-phase coil 923 are parallel to the Y-axis direction, and the diagonal line direction DD2 and the short-side direction SD2 of the second rectangular coil of the second three-phase coil 924 are parallel to the X-axis direction. In the present modification, an X' axis and a Y' axis of a coordinate system obtained by turning the X-axis direction and the Y-axis direction around the Z axis by 45° are used. The diagonal line direction DD1 of the section in the lower-side magnet array 805 and the short-side direction SD1 of the first rectangular coil of the first three-phase coil 923 are set to be parallel to the Y'-axis direction, and the diagonal line direction DD2 and the short-side direction SD2 of the second rectangular coil of the second three-phase coil 924 are set to be parallel to the X'-axis direction In this case, a Y'-axis direction thrust is generated in the first three-phase coil 923, and an X'-axis direction thrust is generated in the second three-phase coil 924. The stage device 1 of the present embodiment generates the X-axis direction thrust and the Y-axis direction thrust by the total force of the Y'-axis direction thrust generated in the first three-phase coil 923 and the X'-axis direction thrust generated in the second three-phase coil 924.

In the present modification, the lower-side magnet array 805 has been described. Since the upper-side magnet array 806 has a configuration that its sections face the sections of the lower-side magnet array 805, the direction of the lattice shape changes similarly also in the upper-side magnet array 806.

### (Third Modification)

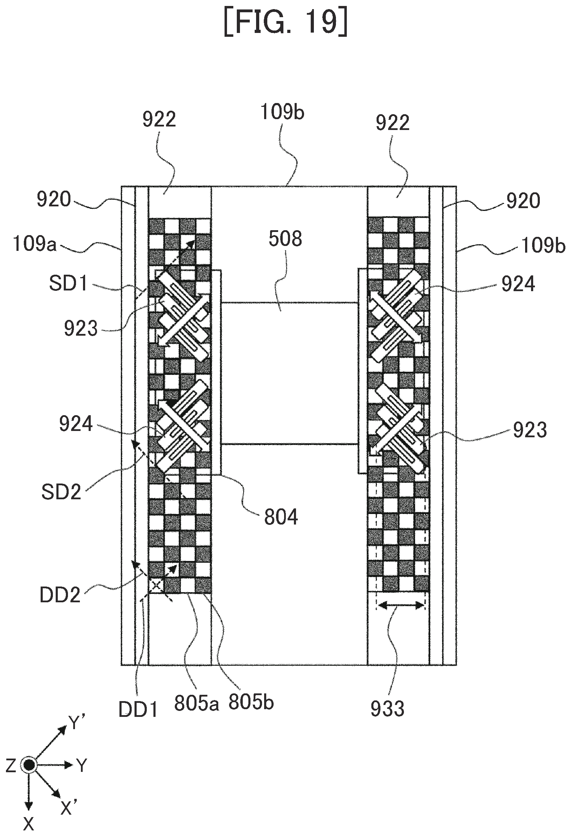

FIG. 19 is an A-A cross section of FIG. 11 in a third modification. In the third modification, a modification of the configuration of the first three-phase coil 923 and the second three-phase coil 924 will be described. The upper-side magnet array 806 and the lower-side magnet array 805 in the present modification are similar to those of the second modification.

In the first three-phase coil 923 of the first embodiment and the first modification, as illustrated in FIGS. 12 and 18, three first rectangular coils are arranged in the short-side direction SD1 so that the short-side parts are aligned linearly. The second three-phase coil 924 is similarly configured. On the other hand, in the first three-phase coil 923 of the third modification, three first rectangular coils are arranged in the short-side direction SD1 so that the short-side parts are deviated in a staircase shape. Similarly, in the second three-phase coil 924 of the third modification, three second rectangular coils are arranged in the short-side direction SD2 so that the short-side parts are deviated in a staircase shape. With the configuration, coil width 933 can be decreased, and the movable stroke in the Y-axis direction can be increased. In FIG. 19, the first rectangular coils are arranged so that their corners overlap in the X-axis direction. Similarly, the second rectangular coils are arranged so that their corners overlap in the X-axis direction. With the arrangement, the coil width 933 can be decreased.

### Second Embodiment

In a second embodiment, a vacuum device having the above-described stage device 1 will be described. FIG. 17 is a schematic cross section of a semiconductor measuring device 2 in which the stage device 1 of the present disclosure is mounted. As an example of the vacuum device, the charged particle radiation device, particularly, the semiconductor measuring device will be described. However, the vacuum device is not limited to the example. In FIG. 17, the stage device 1 is omitted.

The semiconductor measuring device 2 of the second embodiment has the stage device 1 for positioning an object and a vacuum chamber 951 housing the stage device 1. The semiconductor measuring device 2 is, for example, a length measuring SEM as an application device of a scanning electron microscope (SEM).

The semiconductor measuring device 2 has, for example, the stage device 1, the vacuum chamber 951, an electron optical lens tube 952, a vibration damping mount 953, a laser interferometer 954, and a controller 955. The vacuum chamber 951 houses the stage device 1, and the inside is depressurized by a not-illustrated vacuum pump and becomes a vacuum state where the pressure is lower than atmosphere pressure. The vacuum chamber 951 is supported by the vibration damping mount 953.

The semiconductor measuring device 2 positions the sample 104 such as a semiconductor wafer by the stage device 1, emits an electron beam from the electron optical lens tube 952 onto an object, captures a pattern on the object, and performs measurement of the line width of the pattern and evaluation of shape precision. In the stage device 1, the position of the bar mirror 102 is measured by the laser interferometer 954, the position of the Y table 109 on which the scale plate 802 is mounted is measured by the scale head 801, and a sample such as a semiconductor wafer held on the sample stage 103 is position-controlled by the controller 955.

By providing the semiconductor measuring device according to the present embodiment with the stage device with low vibration of the dual-axis motor structure, vibration reduction at the time of positioning a target such as a wafer and positioning time shortening are possible, and leakage of the magnetic field can be suppressed. Therefore, the measurement precision of the semiconductor measuring device as a charged particle radiation device can be improved. Since the levitation mechanism of the stage device is of the magnetic levitation type, it is easy to apply the stage device to a semiconductor measuring device as a vacuum device, and excellent effects such as contamination reduction and suppression of heat generation can be displayed.

As described above, according to the present embodiment, the stage device, the vacuum device, and the charged particle radiation device capable of suppressing vibration of the stator of the motor and performing high-speed positioning can be provided.

Although the embodiments of the present invention have been specifically described above with reference to the drawings, concrete configurations are not limited to the embodiments. Even when there are design changes and the like without departing from the gist of the present invention, they are included in the present invention.

### List of Reference Signs

101: top table (second table), 102: bar mirror, 103: sample stage, 104: sample, 105: permanent magnet, 107: coil, 108: magnetic flux, 109: Y table (first table), 110: Y-axis guide, 111: X table, 112X: X-axis direction thrust, 112Y: Y-axis direction thrust, 113: direction of current, 120: X-axis guide, 401: magnetic attractive force, 402: guide yoke, 403: back yoke, 501: coil, 502: magnet for magnetic levitation, 504: yoke of X-axis motor, 506: yoke of Y-axis motor, 507: water-cooling pipe, 508: water-cooling jacket, 509: support pole, 514: guide yoke, 701: drive center, 702: gravity, 703: levitation table, 704: coil, 705: magnet array, 706: leakage flux, 801: scale head, 802: scale plate, 803: dual-axis motor yoke (yoke), 804: dual-axis motor coil, 805: lower-side magnet array, 805a: N-pole magnet, 805b: S-pole magnet, 806: upper-side magnet array, 806a: N-pole magnet, 806b: S-pole magnet, 807a: N-pole magnet, 807b: S-pole magnet, 808: U-phase coil, 809: V-phase coil, 810: W-phase coil, 901: horizontal component of magnetic flux, 902: vertical component of magnetic flux, 903: coil current, 904: coil current, 905: vertical-direction thrust, 906: horizontal-direction thrust, 920: upper and lower yoke connecting part, 921: upper-side member, 922: lower-side member, 923: first three-phase coil, 924: second three-phase coil, 925: Y-axis direction thrust, 926: X-axis direction thrust, 933: coil width, DD1: diagonal line direction DD1 as one of diagonal line direction, DD2: other diagonal line direction of section, SD1: short-side direction of first rectangular coil, SD2: short-side direction of second rectangular coil

## Claims

1. A stage device for positioning a sample stage in a horizontal plane, comprising:
a first table;
a second table provided with the sample stage, and capable of moving in the horizontal plane in a state where it is magnetically levitated from the first table;
a supporting unit for supporting the second table;
a first dual-axis motor provided for the supporting unit; and
a second dual-axis motor provided for the supporting unit, wherein
each of the first and second dual-axis motors includes:
a yoke having an upper-side member and a lower-side member; and
first and second rectangular coils positioned between the upper-side member and the lower-side member, each fixed to the supporting unit, and whose axial direction is a vertical direction,
a magnet array in which magnets are disposed in square sections arranged in a lattice shape so that magnetic poles in neighboring sections are different is provided in each of an under face of the upper-side member and a top face of the lower-side member, and
the magnetic poles of the magnets in the sections in the magnet array provided for the under face of the upper-side member and those in the magnet array provided for the top face of the lower-side member, which are opposed to each other in the vertical direction are different from each other.

2. The stage device according to claim 1, wherein
the first table is movable in a first horizontal direction parallel to the horizontal plane, and has first and second side walls facing the first horizontal direction and extending in a second horizontal direction parallel to the horizontal plane and perpendicular to the first horizontal direction,
the supporting unit is positioned between the first and second side walls of the first table,
the first dual-axis motor is positioned between the first side wall and the supporting unit,
the second dual-axis motor is positioned between the second side wall and the supporting unit, and
each of the yokes of the first and second dual-axis motors is fixed to the first or second side wall of the first table.

3. The stage device according to claim 2, wherein
the first dual-axis motor has the first rectangular coil on one end side of the first side wall and has the second rectangular coil on the other end side of the first side wall of the first table, and
the second dual-axis motor has the second rectangular coil on one end side of the second side wall opposed to one end of the first side wall in the first horizontal direction and has the first rectangular coil on the other end side of the second side wall.

4. The stage device according to claim 2, wherein
a short-side direction of the first rectangular coil is parallel to one of diagonal line directions of a section in the magnet array, and a short-side direction of the second rectangular coil is parallel to the other diagonal line direction of the section in the magnet array.

5. The stage device according to claim 4, wherein
the first dual-axis motor has a first three-phase coil having three first rectangular coils arranged in one of diagonal line directions of a section in the magnet array, and
the second dual-axis motor has a second three-phase coil having three second rectangular coils arranged in the other diagonal line direction of the section in the magnet array.

6. The stage device according to claim 5, wherein
one of the diagonal line directions of a section in the magnet array is deviated obliquely from the first horizontal direction by 45 degrees.

7. The stage device according to claim 6, wherein
short-side parts of the three first rectangular coils in the first three-phase coil are deviated in a staircase shape, and
short-side parts of the three second rectangular coils in the second three-phase coil are deviated in a staircase shape.

8. The stage device according to claim 5, wherein
the other diagonal line direction of the section in the magnet array is parallel to the second horizontal direction.

9. The stage device according to claim 2, wherein
a section perpendicular to the second horizontal direction of the yoke has a U shape.

10. The stage device according to claim 1, further comprising:
a back yoke fixed to the supporting unit so as to be positioned on the lower side in the vertical direction of the lower-side member of the yoke;
a magnet for magnetic levitation which is fixed to the top face of the back yoke and generates a magnetic attractive force for the lower-side member of the yoke; and
a coil which is fixed to the top face of the back yoke so as to be positioned between the lower-side member of the yoke and the magnet for magnetic levitation and controls the magnetic attractive force, wherein
the back yoke, the magnet for magnetic levitation, and the coil constitute a vertical motor together with the lower-side member of the yoke.

11. The stage device according to claim 10, wherein
the vertical motor makes a levitation part including the supporting unit and the second table magnetically levitate so that height at which the first and second rectangular coils of each of the first and second dual-axis motors are positioned matches the height of gravity of the levitation part.

12. The stage device according to claim 1, wherein
the width in the short-side direction of the first rectangular coil is equal to or larger than half of length of the diagonal line of the section and is equal to or less than length of the diagonal line of the section, and
the width in the short-side direction of the second rectangular coil is equal to or larger than half of length of the diagonal line of the section and is equal to or less than length of the diagonal line of the section.

13. The stage device according to claim 1, wherein the magnet array is a magnet array of a Halbach array.

14. The stage device according to claim 2, further comprising
a guide for guiding movement in the first horizontal direction of the first table.

15. A vacuum device comprising:
a stage device according to any one of claims 1 to 14; and
a vacuum chamber housing the stage device and whose inside is in a vacuum state.

16. A charged particle radiation device comprising:
a stage device according to any one of claims 1 to 14;
a vacuum chamber housing the stage device and whose inside is in a vacuum state; and
an electron optical system lens tube which emits an electron beam to a sample placed on the stage device.
